(19) Europäisches Patentamt / European Patent Office / Office européen des brevets

(11) **EP 2 517 128 B1**

(12) **EUROPÄISCHE PATENTSCHRIFT**

(45) Veröffentlichungstag und Bekanntmachung des Hinweises auf die Patenterteilung:
**01.01.2014 Patentblatt 2014/01**

(21) Anmeldenummer: **10788231.8**

(22) Anmeldetag: **06.10.2010**

(51) Int Cl.:
**G06F 17/50** *(2006.01)*    **G06F 17/13** *(2006.01)*

(86) Internationale Anmeldenummer:
**PCT/EP2010/006094**

(87) Internationale Veröffentlichungsnummer:
**WO 2012/045321 (12.04.2012 Gazette 2012/15)**

(54) **VERFAHREN ZUR ECHTZEITBERECHNUNG DER ZUSTANDSGRÖSSEN EINES HYBRIDEN DIFFERENTIAL-ALGEBRAISCHEN PROZESSMODELLS**

METHOD FOR DETERMINING THE STATE PARAMETERS OF A HYBRID DIFFERENTIAL-ALGEBRAIC PROCESS MODEL IN REAL TIME

PROCÉDÉ DE DÉTERMINATION EN TEMPS RÈEL DES GRANDEURS D'ÉTAT D'UN MODÈLE DE PROCESSUS DE TYPE DIFFÉRENTIEL-ALGÉBRAIC

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**31.10.2012 Patentblatt 2012/44**

(73) Patentinhaber: **Art Systems Software GmbH 33102 Paderborn (DE)**

(72) Erfinder:
• **CURATOLO, Daniel 46145 Oberhausen (DE)**
• **HOFFMANN, Marcus 46145 Oberhausen (DE)**
• **STEIN, Benno 33102 Paderborn (DE)**

(74) Vertreter: **Gesthuysen Patent- und Rechtsanwälte Patentanwälte Postfach 10 13 54 45013 Essen (DE)**

(56) Entgegenhaltungen:
• **NIKOUKHAH R ED - MACIEJOWSKI J M: "A hybrid system formalism for modeling and simulation", INTELLIGENT CONTROL, 2006 IEEE INTERNATIONAL SYMPOSIUM ON, IEEE, PI, 4. Oktober 2006 (2006-10-04), Seiten 1568-1573, XP031420286, ISBN: 978-0-7803-9797-2**
• **VAN DER SCHAFT A J ET AL: "Complementarity Modeling of Hybrid Systems", IEEE TRANSACTIONS ON AUTOMATIC CONTROL, IEEE SERVICE CENTER, LOS ALAMITOS, CA, US, Bd. 43, Nr. 4, 1. April 1998 (1998-04-01), XP011000596, ISSN: 0018-9286**
• **VAN DER SCHAFT A J ET AL: "Compositionality issues in discrete, continuous, and hybrid systems", INTERNATIONAL JOURNAL OF ROBUST AND NONLINEAR CONTROL WILEY UK, Bd. 11, Nr. 5, 30. April 2001 (2001-04-30), Seiten 417-434, XP002635551, ISSN: 1049-8923**
• **"3.3 Hybrid formalisms" In: Tomas Krilavicius: "Hybrid Techniques for Hybrid Systems,", 2006, University of Twente, The Netherlands, University of Twente, The Netherlands, XP002635552, Seiten 30-50, das ganze Dokument**

**Beschreibung**

Die Erfindung betrifft ein Verfahren zur Echtzeitberechnung der Zustandsgrößen eines hybriden differential-algebraischen Prozessmodells (DAP) in aufeinander folgenden Zeitschritten auf einem Prozessrechner mit einer Prozessschnittstelle, wobei der Prozessrechner so eingerichtet ist, dass über die Prozessschnittstelle wenigstens eine Prozessgröße eines physikalischen Prozesses erfasst und/oder eine Ausgangsgröße zur Beeinflussung des physikalischen Prozesses von dem Prozessrechner ausgegeben werden kann, wobei das hybride DAP zumindest durch eine Integratorfunktionalität, eine Bedingungsauswertefunktionalität und bei Identifikation einer Bedingungsänderung durch eine Konsistenzerkennungsfunktionalität für Strukturentscheidungsgrößen gelöst wird, und in Abhängigkeit von Strukturentscheidungsgrößen Teile des hybriden DAP wirksam oder unwirksam sind.

Prozessrechner und auf Prozessrechnern auszuführende Verfahren der zuvor beschriebenen Art werden in technischen Aufgabenstellungen ganz allgemein dazu verwendet, einen physikalischen Prozess gezielt zu beobachten und/oder auf diesen physikalischen Prozess gezielt Einfluss zu nehmen, um ihn in gewünschter Weise zu beeinflussen. Häufig sind auf derartigen Prozessrechnern Prozessmodelle implementiert - also durch mathematische Gleichungen beschreibbare funktionale physikalisch-technische Zusammenhänge -, die beispielsweise zu Regelungszwecken ein mathematisches Modell des angeschlossenen physikalischen Prozesses darstellen, oder die einen von dem angeschlossenen physikalischen Prozess verschiedenen Prozess mathematisch nachbilden, der beispielsweise zur Anregung des "echten" physikalischen Prozesses ein Stück Wirklichkeit simuliert, wie dies beispielsweise von Simulatoren bekannt ist. Derartige Prozessrechner und Verfahren sind insbesondere aus dem Bereich der Steuergeräteentwicklung (Rapid-Control-Prototyping, Hardware-in-the-Loop-Tests) nicht mehr wegzudenken.

Je nach Art des auf dem Prozessrechner zu modellierenden und zu berechnenden Prozesses weist das Prozessmodell unterschiedliche mathematische Eigenschaften auf. Viele Prozessmodelle bestehen aus einem System von - linearen  oder nicht nichtlinearen - Differentialgleichungen, im einfachsten Fall aus einer einzigen Differentialgleichung. Diese Differentialgleichungen werden mit den bekannten numerischen Verfahren gelöst, nachfolgend Integratorfunktionalität genannt.

Da der Prozessrechner üblicherweise mit einem echten physikalischen Prozess in Verbindung steht, ist es notwendig, dass Prozessmodell in Echtzeit zu berechnen, so dass Prozessgrößen des angeschlossenen physikalischen Prozesses in dem gewünschten Zeitraster - definiert durch die aufeinander folgenden Zeitschritte auf dem Prozessrechner - erfasst und weiterverarbeitet werden können, bzw. von dem Prozessrechner Ausgangsgrößen zur Beeinflussung des physikalischen Prozesses ausgegeben werden können.

Viele Prozessmodelle umfassen neben Differentialgleichungen oder Differentialgleichungssystemen auch algebraische Gleichungen, die typischerweise das Verhalten von Erhaltungsgrößen in dem Prozess beschreiben. Einfache Zusammenhänge dieser Art sind beispielsweise Ströme in Knoten eines elektrischen Netzwerks, die Energiekonstanz in einem abgeschlossenen System, der Volumenstrom eines inkompressiblen Mediums, die Impulserhaltung in einem Mehrkörpersystem und andere kinetische Nebenbedingungen. Derartige Modelle werden als differential-algebraische Prozessmodelle bezeichnet, im Folgenden kurz "DAP".

DAP sind häufig strukturinvariant, das heißt, dass die Zustandsgrößen des Prozessmodells sowie die Zusammenhänge zwischen den Zustandsgrößen a priori feststehen, sich das mathematische Gerüst als solches nicht ändert, weder über die Zeit noch in Abhängigkeit von anderen Bedingungen. Solche Systeme können aufgrund ihrer Strukturinvarianz vor Laufzeit der Berechnung in ein vollständiges algorithmisches Modell - zum Beispiel in der Form von C-Code - überführt werden, und vor Berechnungsstart können die strukturinvarianten Modelle mit den bekannten mathematischen Methoden zur Minimierung des Rechnungsaufwandes optimiert werden, also beispielsweise durch BLT-Transformationen, Tearing oder Sparse-Matrix-Verfahren. Aus dem laufzeitoptimierten algorithmischen Modell kann dann ein auf dem Prozessrechner ausführbares Prozessmodell erstellt werden, also beispielsweise durch Kompilation des oben angeführten C-Codes.

Komplexere Prozessmodelle sind jedoch häufig strukturvariant, sie verfügen über verschiedene Modi, die sich dadurch auszeichnen, dass zum Beispiel verschiedene Zusammenstellungen von Zustandsgrößen oder unterschiedliche Zusammenhänge zwischen einer gleich bleibenden Auswahl an Zustandsgrößen die Funktionalität des Prozessmodells beschreiben, wobei diese unterschiedlichen Modi des Prozessmodells in Abhängigkeit von bestimmten Bedingungen aktiviert oder deaktiviert sind. Die Größen, die darüber entscheiden, ob ein hybrides DAP eine Strukturänderung erfährt, werden hier als Strukturentscheidungsgrößen bezeichnet; Strukturentscheidungsgrößen sind üblicherweise diskrete Variablen, deren Werte sich in Abhängigkeit von Bedingungsgleichungen ändern, wobei die Bedingungsgleichungen von der eingangs genannten Bedingungsauswertefunktionalität ausgewertet werden. Ein strukturvariantes differential-algebraisches Modell wird als hybrides DAP bezeichnet. In Abhängigkeit von den Strukturentscheidungsgrößen des Prozessmodells werden also verschiedene Teile des hybriden DAP aktiviert oder deaktiviert, so dass ein bestimmter Modus des hybriden DAP weniger komplex (im Sinne von umfassend) ist, als das hybride DAP, das omnipotent ist und alle möglichen Modi - also mögliche aktive Strukturen des hybriden DAP - umfasst.

Um den Modus eines hybriden DAP berechnen zu können, weisen bekannte Berechnungsverfahren eine Integratorfunktionalität auf, also einen an sich bekannten numerischen Integrator zur Lösung von Differentialgleichungen.

Im Rahmen der Bedingungsauswertefunktionalität werden Bedingungsgleichungen ausgewertet, wodurch sich Strukturentscheidungsgrößen ändern können. Infolge der Änderung einer Strukturentscheidungsgröße - oder der Änderung mehrerer Strukturentscheidungsgrößen - kann sich der Modus des Prozessmodells ändern, es handelt sich jedoch lediglich um eine notwendige Voraussetzung für einen Moduswechsel.

Ein Beispiel für ein hybrides DAP könnte ein Motor mit zugehörigem Getriebestrang sein, wobei die verschiedenen Getriebestufen verschiedene Strukturen des hybriden DAP sind, von denen beispielsweise immer nur eine Getriebestufe wirksam sein kann. Strukturentscheidungsgrößen könnten in diesem Beispiel abhängig sein von der Motordrehzahl, der Leistungsanforderung des Fahrers und der mechanischen Last am Getriebe. In Abhängigkeit von diesen Strukturentscheidungsgrößen entscheidet sich, ob innerhalb eines Berechnungsschrittes bzw. von einem Berechnungsschritt auf den nächsten Berechnungsschritt eine Strukturänderung vorliegt oder nicht.

Die Bedingungsauswertefunktionalität alleine garantiert nicht, dass ein stabiler Satz an Strukturentscheidungsgrößen - genauer: ein stabiler Satz von Werten für die Strukturentscheidungsgrößen - gefunden wird, dazu dient die eingangs erwähnte Konsistenzerkennungsfunktionalität. Die Konsistenzerkennungsfunktionalität wird gegebenenfalls iterativ ausgeführt, wobei Konsistenz der Strukturentscheidungsgrößen dann vorliegt, wenn sich die Strukturentscheidungsgrößen - genauer: sich die Werte für die einzelnen Strukturentscheidungsgrößen - nicht mehr ändern. Diese Konsistenzerkennungsfunktionalität wird immer dann ausgeführt, wenn die Bedingungsauswertefunktionalität die Änderung wenigstens einer Strukturentscheidungsgröße erkannt hat. Innerhalb der Konsistenzerkennungsfunktionalität werden die zuvor berechneten Werte für die Zustandsgrößen und die Zeit "festgehalten", die Ableitungen der Zustandsgrößen, algebraische Variablen und die Bedingungsgleichungen werden jedoch immer wieder neu ausgewertet, wobei abschließend immer ermittelt wird, ob die zuvor ermittelten Werte für die Strukturentscheidungsgrößen mit den neu ermittelten Werten für die Strukturentscheidungsgrößen übereinstimmen. Ist dies der Fall, endet die Konsistenzprüfung, ist dies nicht der Fall, muss die Konsistenzprüfung fortgeführt werden, bis im Idealfall ein stabiler Zustand erreicht ist. In der Praxis muss die Iteration abgebrochen werden, wenn keine Konsistenz erzielt wird, dann greifen andere Vorgehensweisen, die hier jedoch nicht Gegenstand der Betrachtung sind. Während der Durchführung der Konsistenzerkennungsfunktionalität können infolge der Änderung von Strukturentscheidungsgrößen wechselnde Anteile des hybriden DAP wirksam geworden sein, die Konsistenzprüfung setzt also voraus, dass ihr das vollständige hybride DAP zur Verfügung steht.

In einem weiteren Schritt kann ermittelt werden, zu welchem Zeitpunkt genau die Strukturentscheidungsgröße einen anderen Wert angenommen hat - die Auswertung einer Bedingungsgleichung also zu einem anderen Ergebnis geführt hat -, die einen Strukturwechsel des hybriden DAP bewirken kann. Dieser Zeitpunkt kann irgendwo in dem Berechnungsintervall zwischen zwei diskreten Berechnungszeitpunkten liegen. Der Berechnung der Bedingungsauswertefunktion liegen in der Regel Gleichungen bzw. Ungleichungen zurunde, durch deren Auswertung sich Strukturentscheidungsgrößen ändern. Mathematisch wird hier der Nulldurchgang einer Funktion ermittelt, wobei der Zeitpunkt $t_c$ des Nulldurchganges dieser Funktion dem Zeitpunkt der Bedingungsänderung entspricht. Ist dieser Zeitpunkt $t_c$ der Bedingungsänderung bekannt, wird die Konsistenzerkennungsfunktionalität in Gang gesetzt, deren Aufgabe es ist, im Zeitpunkt $t_c$ der Bedingungsänderung denjenigen Satz von Strukturentscheidungsgrößen bzw. von Werten für Strukturentscheidungsgrößen zu ermitteln, der stabil ist und zunächst keine weitere Änderung nach sich zieht. Dazu muss stets das gesamte hybride DAP wenigstens einmal erneut berechnet werden.

Aus der beschriebenen Vorgehensweise ist ohne Weiteres ersichtlich, dass bei Erkennen einer Bedingungsänderung innerhalb eines Berechnungsschrittes wenigstens eine zusätzliche Integration des hybriden DAP erforderlich ist gegenüber der "normalen" Integration des wirksamen Teils eines hybriden DAPs, wenn keine Bedingungsänderung vorliegt. Wenn - wie zuvor beschrieben - eine Rückrechnung auf den genauen Zeitpunkt zwischen zwei Berechnungsschritten erfolgt, dann ist im Falle einer Bedingungsänderung auch wenigstens eine noch weitere - also dritte - Integration des hybriden DAP erforderlich. Es ist unmittelbar einleuchtend, dass dieser Mehraufwand innerhalb der Echtzeitberechnung zu erheblichen Problemen führen kann, da der zeitliche Mehraufwand möglicherweise so hoch ist, dass innerhalb des gewünschten Zeitrasters - Abtastperiodendauer der Echtzeitberechnung - eine Berechnung nicht möglich ist, und eine Zeitüberschreitung erfolgt, die bei den hier betrachteten Systemen, die einen direkten Zusammenhang über die Prozessschnittstelle zu einem physikalischen Prozess aufweisen, schwerwiegende Folgen haben kann. Das Laufzeitverhalten der Echtzeitberechnung der Zustandsgrößen von hybriden DAPs ist bei den zuvor geschilderten Verfahren schwer kalkulierbar, die Berechnungszeit im Falle einer Bedingungsänderung des hybriden DAP kann die Berechnungszeit ohne Vorliegen einer Bedingungsänderung um ein Vielfaches überschreiten.

Der vorliegenden Erfindung liegt daher die Aufgabe zugrunde, ein Verfahren zur Berechnung der Zustandsgrößen eines hybriden DAPs zur Verfügung zu stellen, mit dem eine schnelle Berechnung auch bei einer Bedingungsänderung des hybriden DAP möglich ist, jedenfalls die nötige Berechnungszeit im Falle der Änderung einer Strukturentscheidungsgröße gegenüber den bekannten Verfahren verringert wird.

Die hergeleitete und beschriebene Aufgabe ist bei dem zuvor erläuterten Verfahren zur Berechnung der Zustandsgrößen eines hybriden differentialalgebraischen Prozessmodells dadurch gelöst, dass die Konsistenzerkennungsfunktionalität in einer sortierten Konsistenzhandhabungsfunktion (KHF) ausgeführt wird, wobei ein erster Teil der sortierten KHF alle bedingungsunabhängigen Anteile des hybriden DAP umfasst, ein zweiter Teil der sortierten KHF alle bedingungsabhängigen Anteile des hybriden DAP umfasst, die Strukturentscheidungsgrößen beeinflussen, ein dritter Teil der sortierten KHF alle bedingungsabhängigen Anteile des hybriden DAP umfasst, die keine Strukturentscheidungsgrößen beeinflussen, wobei im Falle einer Bedingungsänderung zur Erkennung eines konsistenten Satzes von Strukturentscheidungsgrößen der erste Teil und der dritte Teil der sortierten KHF nur einmal und nur der zweite Teil der strukturierten KHF ggf. mehrfach ausgeführt wird, wobei mit jeder Ausführung der Integratorfunktionalität auch die sortierte KHF ausgeführt wird.

Bei dem erfindungsgemäßen Verfahren wird auf die traditionelle Untergliederung zwischen der Integratorfunktionalität, die auf alle Gleichungen des hybriden DAP angewendet wird und der Bedingungsauswertefunktionalität, einhergehend mit der Konsistenzerkennnungsfunktionalität im Falle der Änderung einer Strukturentscheidungsgröße, in der nochmals mindestens einmal das gesamte hybride DAP ausgewertet wird, verzichtet. Durch die Sortierung von großen Teilen des vollständigen hybriden DAP und dessen Berechnung in der Konsistenzhandhabungsfunktion wird darüber hinaus eine unnötige Mehrfachberechnung von großen Teilen des hybriden DAP vermieden. Der erste Teil der sortierten KHF wird in jedem Berechnungsschritt durchgeführt, das Ergebnis der Berechnung des ersten Teils der KHF ist zudem unabhängig davon, ob eine Bedingungsänderung vorliegt, da der erste Teil der sortierten KHF alle bedingungsunabhängigen Anteile des hybriden DAP umfasst.

Der zweite Teil der sortierten KHF ist entscheidend dafür, ob eine Bedingungsänderung des hybriden DAP vorliegt oder nicht, denn in diesem zweiten Teil der sortierten KHF sind bestimmungsgemäß alle bedingungsabhängigen Anteile des hybriden DAP zusammengefasst, die ihrerseits auch Strukturentscheidungsgrößen beeinflussen können, also bestimmend dafür sind, wie sich Strukturentscheidungsgrößen entwickeln. Dieser zweite Teil der sortierten KHF ist demnach zu berechnen - und gegebenenfalls mehrfach zu berechnen -, wenn eine Bedingungsänderung vorliegt und jener fortan wirksame Satz von Strukturentscheidungsgrößen bzw. Werten von Strukturentscheidungsgrößen des hybriden DAP zu berechnen ist, der konsistent und stabil ist. Die Stabilität des Satzes von Strukturentscheidungsgrößen bzw. der Werte von Strukturentscheidungsgrößen wird dadurch erkannt, dass sich die Werte von einem auf den nächsten Iterationsschritt des zweiten Teils der KHF nicht ändern. Im Falle einer Bedingungsänderung muss also lediglich über den zweiten Teil der sortierten KHF iteriert werden und nicht - wie aus dem Stand der Technik bekannt - über das vollständige hybride DAP bzw. die vollständige Konsistenzerkennungsfunktionalität. Hieraus resultiert eine erhebliche Zeitersparnis gegenüber den konventionellen Verfahren.

Der dritte Teil der sortierten KHF ist in jedem Berechnungsschritt - genau wie der erste Teil der sortierten KHF - nur ein einziges Mal zu berechnen, da zuvor - also bei der Berechnung des zweiten Teils der sortierten KHF - der nunmehr stabile Satz von Strukturentscheidungsgrößen ermittelt worden ist und die nachfolgende Berechnung aller zwar bedingungsabhängigen Anteile des hybriden DAP, die bestimmungsgemäß Strukturentscheidungsgrößen aber nicht beeinflussen, nicht mehr zu einer Änderung von Bedingungsgleichungen und damit auch nicht mehr zu einer Änderung von Strukturentscheidungsgrößen und damit der Struktur des hybriden DAP führen kann.

Gemäß einer bevorzugten Ausgestaltung des erfindungsgemäßen Verfahrens werden im zweiten Teil der sortierten Konsistenzhandhabungsfunktion die Anteile des hybriden DAP in Kausalketten von Strukturentscheidungsgrößen untergliedert. Damit ist gemeint, dass bei Änderung einer bestimmten Strukturentscheidungsgröße nur diejenigen Teile des hybriden DAP bzw. der weiteren Bedingungsgleichungen ausgewertet werden, auf die diese Änderung der bestimmten Strukturentscheidungsgröße überhaupt Einfluss hat. Dadurch werden Kausalketten gebildet, so dass nur jene Kausalketten neu berechnet werden, in denen sich Strukturentscheidungsgrößen geändert haben. Dadurch, dass bei Ausführung der sortierten Konsistenzhandhabungsfunktion nunmehr nur noch über einen noch spezielleren und damit kleineren Teil iteriert wird, wird gegenüber konventionellen Verfahren ein noch größerer Zeitgewinn erzielt.

Die Erfindung ist ferner gerichtet auf ein Computerprogramm mit Programmcode-Mitteln, um alle mit Hilfe des vorgenannten Prozessrechners vollzogenen erfindungsgemäßen Verfahrensschritte durchzuführen, wenn das Programm auf einer Datenverarbeitungsanlage ausgeführt wird. Die Erfindung ist auch gerichtet auf ein solches Computerprogramm mit Programmcode-Mitteln, die auf einem computerlesbaren Datenträger gespeichert sind.

Nachfolgend wird das erfindungsgemäße Verfahren zur Berechnung der Zustandsgrößen eines hybriden differential-algebraischen Prozessmodells anhand der folgenden Beschreibung eines Ausführungsbeispiels in Verbindung mit der Zeichnung erläutert. In der Zeichnung zeigen

Fig. 1    die aus dem Stand der Technik bekannte Vorgehensweise zur Erkennung der Bedingungsänderung eines hybriden DAPs,

Fig. 2 das Ablaufdiagramm eines konventionellen Verfahrens zur Berechnung der Zustandsgrößen eines hybriden DAPs und

Fig. 3 das Ablaufdiagramm zur Berechnung der Zustandsgrößen eines hybriden DAPs gemäß dem erfindungsgemäßen Verfahren.

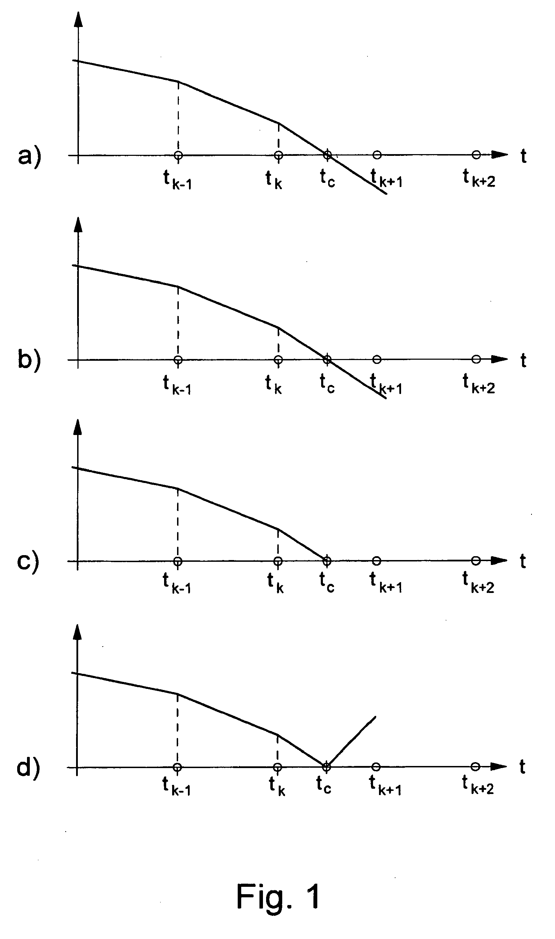

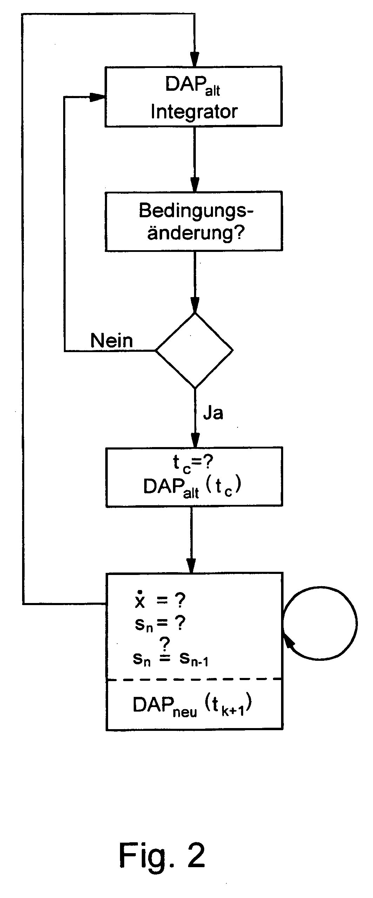

In den Figuren 1 und 2 sind verschiedene Aspekte bekannter Verfahren zur Berechnung der Zustandsgrößen eines hybriden differential-algebraischen Prozessmodells (DAP) dargestellt, wobei Figur 1 aufeinander folgende, äquidistante Berechnungsintervalle zeigt, die jeweils von den Zeitpunkten $t_{k-1}$, $t_k$, $t_{k+1}$, usw. begrenzt sind. Wie eingangs bereits beschrieben worden ist, zeichnen sich hybride DAPs dadurch aus, dass die wirksamen Teile des hybriden DAP in Abhängigkeit von Strukturentscheidungsgrößen s variieren können.

Um eine Bedingungsänderung und damit einhergehend eine mögliche Strukturänderung innerhalb des hybriden DAP erkennen zu können, sind aus dem Stand der Technik bekannte Verfahren zur Berechnung der Zustandsgrößen eines hybriden DAPs mit einer Bedingungsauswertefunktionalität ausgestattet, die zunächst erkennt, dass überhaupt eine Änderung in der Auswertung einer Bedingungsgleichung stattgefunden hat.

Ferner sind bekannte Verfahren auch mit einer Konsistenzerkennungsfunktionalität ausgestattet, die in der Lage ist, stabile Werte von Strukturentscheidungsgrößen zu ermitteln; dies ist in den Figuren 1a) bis 1d) dargestellt.

Über der Zeitachse t ist jeweils dargestellt der Graph einer Bedingungsgleichung des hybriden DAP, bei dessen Nulldurchgang eine Bedingungsänderung vorliegt, so dass der Nulldurchgang zur Feststellung einer Bedingungsänderung zu detektieren ist. Ein solcher Nulldurchgang liegt hier vor im Berechnungsintervall vom Zeitpunkt $t_k$ auf den Zeitpunkt $t_{k+1}$. Da die Gleichungen des hybriden DAP üblicherweise nur in den diskreten Zeitpunkten $t_{k-1}$, $t_k$, $t_{k+1}$ ausgewertet werden, muss der exakte Zeitpunkt $t_c$ des Nulldurchgangs der Bedingungsgleichung über bekannte Iterationstechniken zur Nullpunktbestimmung ermittelt werden (Fig. 1b)). Das in Fig. 1a) dargestellte Erkennen des Nulldurchgangs der Bedingungsgleichung ist Aufgabe der Bedingungsauswertefunktionalität.

Ist der Zeitpunkt $t_c$ bekannt, zu dem eine Bedingungsänderung stattgefunden hat, so muss nachfolgend ermittelt werden, welche Werte sich für die Strukturentscheidungsgrößen stabil und konsistent einstellen, wobei es in diesem Schritt erforderlich sein kann, das vollständige hybride DAP mehrfach zu berechnen - Bedingungsgleichungen und Ableitungen der Zustandsgrößen -, bis ein stabiler Änderungszustand des hybriden DAP gefunden wird, in dem sich also die Strukturentscheidungsgrößen nicht mehr ändern (Fig. 1c). Auf Grundlage der Änderung einer Strukturentscheidungsgröße oder mehrerer Strukturentscheidungsgrößen können andere Teile des hybriden DAP wirksam werden, müssen es jedoch nicht, die Änderung einer Strukturentscheidungsgröße ist eine notwendige, aber keine hinreichende Bedingung für eine Strukturänderung. Wenn der neue wirksame Teil des hybriden DAP stabil ermittelt worden ist, erfolgt eine weitere Integration des nunmehr wirksamen Teils des hybriden DAP im Zwischenschrittbereich von $t_c$ bis zum Zeitpunkt $t_{k+1}$ (Fig. 1d)).

Wenn bei bekannten Berechnungstechniken in einem Berechnungsschritt des hybriden DAP eine Bedingungsänderung erkannt wird, dann ist neben der sonst in einem Berechnungsschritt immer erforderlichen Integration des wirksamen Teils des hybriden DAP wenigstens eine weitere Auswertung des gesamten hybriden DAP erforderlich, um den nach der Bedingungsänderung wirksamen Teil des hybriden DAP stabil zu ermitteln - gegebenenfalls sind hier auch weitere Integrationen erforderlich (Fig. 1c)) -, wenn eine Zwischenschrittberechnung erfolgt, wie in Fig. 1 dargestellt, dann ist auch eine dritte Auswertung innerhalb eines Zeitschrittes erforderlich. Dies ist insgesamt die Problematik bei der Echtzeitberechnung von hybriden DAP. Der Berechnungsmehraufwand bei einer Bedingungsänderung kann leicht zu einer Vervielfachung der Berechnungszeit des hybriden DAP führen, so dass die erforderliche Zeit zur Berechnung ein Abtastintervall überschreitet und damit das hybride DAP nicht mehr unter Echtzeitbedingungen berechnet werden kann.

In Fig. 2 ist ein aus dem Stand der Technik bekanntes Verfahren zur Echtzeitberechnung der Zustandsgrößen eines hybriden DAPs durch ein Ablaufdiagramm dargestellt. Ist ein wirksamer Teil des hybriden DAP bestimmt, wird dieser Teil des hybriden DAP (DAP$_{alt}$) mit einer an sich bekannten Integratorfunktionalität (Integrator) berechnet. Der in dem obersten Block in Fig. 2 dargestellte Integrator arbeitet dabei mit allen Gleichungen des hybriden DAP, außer mit den Gleichungen, mittels derer eine Strukturänderung erkannt wird. Berechnet werden durch den Integrator also nur die als wirksam erkannten Teile des hybriden DAP. In dem darauf folgenden Verfahrensschritt - Bedingungsänderung? - werden die Bedingungsgleichungen ausgewertet, die die Änderung einer Strukturentscheidungsgröße anzeigen. Hierbei handelt es sich üblicherweise um die Erkennung eines Nulldurchgangs einer Bedingungsgleichung. Wird eine Bedingungsänderung nicht erkannt, berechnet die in Form des Integrators zuoberst dargestellte Integratorfunktionalität auf Grundlage des unverändert wirksamen Teils des hybriden DAP die Zustandsgrößen des hybriden DAP für den nächsten Abtastschritt in der Echtzeitberechnung. In dieser Berechnungsschleife wird die Integratorfunktionalität in jedem Berechnungsschritt einmal aufgerufen.

Wird eine Bedingungsänderung jedoch erkannt, erfolgt die genaue Berechnung des Zeitpunktes $t_c$ des Nulldurchgangs - $t_c$=? - der Bedingungsgleichung und die Berechnung des zuvor wirksamen Teils des hybriden DAP in diesem Zeitpunkt ($DAP_{alt}(t_c)$), so dass die Integratorfunktionalität im Falle einer Bedingungsänderung hier ein weiteres Mal zur Anwendung kommt. Letztlich wird in dem zuunterst dargestellten Block durch die Konsistenzerkennungsfunktionalität derjenige Satz von stabilen Strukturentscheidungsgrößen - symbolisiert durch s - ermittelt, der zukünftig wirksam ist, wobei diese Konsistenzerkennungsfunktionalität auf alle Gleichungen des hybriden DAP zurückgreifen muss, also auch auf die Bedingungsgleichungen. Hier wird folglich das hybride DAP wenigstens ein weiteres Mal berechnet, möglicherweise sind hier auch wiederum Iterationen - also Mehrfachberechnungen des hybriden DAP - erforderlich, um einen stabilen Satz der Strukturentscheidungsgrößen zu ermitteln — $s_n = s_{n-1}$ —. Ergebnis der Konsistenzerkennungsfunktionalität kann sein, dass ein neuer wirksamer Teil des hybriden DAP resultiert ($DAP_{neu}$), dies muss jedoch nicht so sein. Erneut wird deutlich, dass im Falle einer Bedingungsänderung die Berechnungszeit erheblich ansteigen kann, nämlich die Berechnungszeit für einen Berechnungsschritt ohne Bedingungsänderung um ein Vielfaches übersteigen kann.

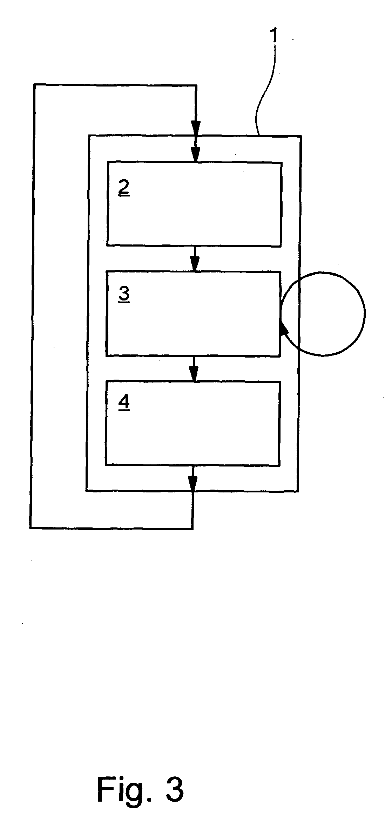

In Fig. 3 ist schließlich dargestellt das erfindungsgemäße Verfahren zur Echtzeitberechnung der Zustandsgrößen eines hybriden DAPs. Die aus dem Stand der Technik bekannte Trennung zwischen Integratorfunktionalität, Bedingungsauswertefunktionalität und Konsistenzerkennungsfunktionalität ist hier durchbrochen worden. Das Verfahren beruht zunächst darauf, dass die Konsistenzerkennungsfunktionalität in einer gemeinsamen sortierten Konsistenzhandhabungsfunktion (KHF) 1 ausgeführt wird, wobei die Sortierung so geschickt gewählt wird, dass für den Fall einer Bedingungsänderung innerhalb des hybriden DAP insgesamt kleinere Berechnungszeiten notwendig sind, um den konsistenten Satz von Strukturentscheidungsgrößen des hybriden DAP zu ermitteln und zu berechnen.

Dazu ist vorgesehen, die sortierte Konsistenzhandhabungsfunktion 1 in insgesamt drei Teile 2, 3, 4 zu untergliedern. Der erste Teil 2 der sortierten Konsistenzhandhabungsfunktion 1 umfasst dabei alle strukturunabhängigen Anteile des hybriden DAP. Diese Anteile des hybriden DAP müssen also immer berechnet werden, unabhängig davon, welche Teile des hybriden DAP wirksam sind und welche Werte die einzelnen Strukturentscheidungsgrößen aufweisen. Die Berechnung dieser strukturunabhängigen Anteile des hybriden DAP ist daher immer erforderlich.

Ferner ist vorgesehen, dass ein zweiter Teil 3 der sortierten KHF alle bedingungsabhängigen Anteile des hybriden DAP umfasst, die wiederum Strukturentscheidungsgrößen beeinflussen. Da nur in diesem zweiten Teil 3 der sortierten KHF 1 Einfluss genommen werden kann auf die Strukturentscheidungsgrößen, ist auch nur dieser zweite Teil 3 von Interesse für das Auffinden eines stabilen Satzes von Werten für die Strukturentscheidungsgrößen.

Letztlich sind in einem dritten Teil 4 der sortierten KHF 1 alle bedingungsabhängigen Anteile des hybriden DAP umfasst, die keine Strukturentscheidungsgrößen beeinflussen, so dass die Berechnung der in diesem dritten Teil 4 enthaltenen Teile des Prozessmodells nicht von Bedeutung sind, wenn eine Konsistenzerkennungsfunktionalität ausgeführt wird, da das Ergebnis dieser Berechnung keinen Einfluss auf mögliche Strukturentscheidungsgrößen hat.

Die aufgezeigte Sortierung des hybriden differential-algebraischen Prozessmodells hat den Vorteil, dass im Falle der Bedingungsänderung innerhalb des hybriden DAP zur Erkennung des stabilen Satzes von Strukturentscheidungsgrößen der erste Teil 2 und der dritte Teil 4 der sortierten KHF 1 nur einmal zu berechnen ist. Der zweite, im Regelfall - jedenfalls gemessen an dem vollständigen hybriden DAP - sehr kleine Teil 3 der strukturierten KHF 1 wird in dem Fall einer Bedingungsänderung gegebenenfalls mehrfach ausgeführt, bis eine konsistente und stabile Wertebelegung für die Strukturentscheidungsgrößen aufgefunden worden ist. Es ist unmittelbar einleuchtend, dass mit der sortierten KHF 1 gleichzeitig auch die Integratorfunktionalität stets ausgeführt werden muss bzw. mit jeder Ausführung der Integratorfunktionalität auch die sortierte KHF 1 ausgeführt wird.

Wie in Fig. 3 zu erkennen ist, gibt es keine Fallunterscheidungen mehr in der Berechnung hinsichtlich des Erkennens oder des Nichterkennens einer Bedingungsänderung, es werden stets alle Berechnungsschritte ausgeführt. Damit ist zwar insgesamt die Berechnungsgrundlast bei dem in Fig. 3 dargestellten Verfahren höher als im Falle bekannter Verfahren beim Ausbleiben einer Bedingungsänderung, dafür sind aber die Anstiege in der Berechnungszeit, auch absolut gesehen, bei Vorliegen einer Bedingungsänderung erheblich geringer als dies bei den klassischen Verfahren der Fall ist, weil zum Auffinden des neuen stabilen und konsistenten Wertesatzes für die Strukturentscheidungsgröße lediglich der zweite Teil 3 der sortierten Konsistenzhandhabungsfunktion 1 zu berechnen ist, der seinerseits nur einen ausgewählten Teil des hybriden DAP überhaupt umfasst und daher weniger rechenintensiv ist, als die Berechnung der Konsistenzerkennungsfunktionalität bei bekannten Verfahren, die in jeder Iteration auf Grundlage des vollständigen hybriden DAPs ausgeführt wird, innerhalb derer also alle Gleichungen des hybriden DAP berechnet werden inklusive der Bedingungsgleichungen für das Vorliegen einer Bedingungsänderung.

**Patentansprüche**

1. Verfahren zur Echtzeitberechnung der Zustandsgrößen eines hybriden differential-algebraischen Prozessmodells (DAP) in aufeinander folgenden Zeitschritten auf einem Prozessrechner mit einer Prozessschnittstelle, wobei der Prozessrechner so eingerichtet ist, dass über die Prozessschnittstelle wenigstens eine Prozessgröße eines physikalischen Prozesses erfasst und/oder eine Ausgangsgröße zur Beeinflussung des physikalischen Prozesses von dem Prozessrechner ausgegeben werden kann, wobei das hybride DAP zumindest durch eine Integratorfunktionalität, eine Bedingungsauswertefunktionalität und bei Identifikation einer Bedingungsänderung durch eine Konsistenzerkennungsfunktionalität für Strukturentscheidungsgrößen gelöst wird, und in Abhängigkeit von Strukturentscheidungsgrößen Teile des hybriden DAP wirksam oder unwirksam sind,

**dadurch gekennzeichnet,**

**dass** die Konsistenzerkennungsfunktionalität in einer sortierten Konsistenzhandhabungsfunktion (KHF, 1) ausgeführt wird, wobei ein erster Teil (2) der sortierten KHF (1) alle bedingungsunabhängigen Anteile des hybriden DAP umfasst, ein zweiter Teil (3) der sortierten KHF (1) alle bedingungsabhängigen Anteile des hybriden DAP umfasst, die Strukturentscheidungsgrößen beeinflussen, ein dritter Teil (4) der sortierten KHF (1) alle bedingungsabhängigen Anteile des hybriden DAP umfasst, die keine Strukturentscheidungsgrößen beeinflussen, wobei im Falle einer Bedingungsänderung zur Erkennung eines konsistenten Satzes von Strukturentscheidungsgrößen der erste Teil (2) und der dritte (4) Teil der sortierten KHF (1) nur einmal und nur der zweite Teil (3) der strukturierten KHF (1) ggf. mehrfach ausgeführt wird, wobei mit jeder Ausführung der Integratorfunktionalität auch die sortierte KHF (1) ausgeführt wird.

2. Verfahren nach Anspruch 1, **dadurch gekennzeichnet, dass** im zweiten Teil (3) der sortierten Konsistenzhandhabungsfunktion (1) die Anteile des hybriden DAP in Kausalketten von Strukturentscheidungsgrößen untergliedert werden, und nur jene Kausalketten neu berechnet werden, in denen sich Strukturentscheidungsgrößen geändert haben.

3. Computerprogramm mit Programmcode-Mitteln, um alle mit Hilfe des Prozessrechners vollzogenen Schritte gemäß den voranstehenden Ansprüchen durchzuführen, wenn das Programm auf dem Prozessrechner ausgeführt wird.

4. Computerprogramm mit Programmcode-Mitteln gemäß Anspruch 3, die auf einem computerlesbaren Datenträger gespeichert sind.

## Claims

1. Method for real time computation of the state variables of a hybrid differential-algebraic process model (DAP) in succeeding time steps on a process computer with a process interface, the process computer being set up such that via the process interface at least one process variable of a physical process can be detected and/or one output for influencing the physical process can be output by the process computer, the hybrid DAP being solved at least by one integrator functionality, one condition evaluation functionality and with identification of a condition change by a consistency detection functionality for structure decision variables, and depending on the structure decision variables parts of the hybrid DAP being active or inactive,

**characterized in**

**that** the consistency detection functionality is carried out in a sorted consistency handling function (KHF, 1), a first part (2) of the sorted KHF (1) comprising all condition-dependent portions of the hybrid DAP, a second part (3) of the sorted KHF (1) comprising all condition-dependent portions of the hybrid DAP which influence the structure decision variables, a third part (4) of the sorted KHF (1) comprising all condition-dependent portions of the hybrid DAP which do not influence the structure decision variables, in the case of a condition change for detection of consistent set of structure decision variables the first part (2) and the third part (4) of the sorted KHF (1) being carried out only once and only the second part (3) of the structured KHF (1) optionally being carried out repeatedly, with each execution of the integrator functionality, the sorted KHF (1) also being carried out.

2. Method according to claim 1, **characterized in that** in the second part (3) of the sorted consistency handling function (1), the portions of the hybrid DAP are divided into causal chains of structure decision variables, and only those causal chains are recomputed in which structure decision variables have changed.

3. Computer program with program code means in order to carry out all steps completed using the process computer according to the preceding claims when the program is executed on the process computer.

4. Computer program with program code means according to claim 3, which are stored on a computer-readable data medium.

## Revendications

1. Procédé de calcul en temps réel des grandeurs d'état d'un modèle différentiel-algébrique hybride de processus (DAP) par étapes successives sur un calculateur de processus doté d'une interface de processus,

le calculateur de processus étant conçu pour saisir au moins une grandeur d'un processus physique par l'intermédiaire de l'interface de processus et/ou pour faire délivrer par le calculateur de processus une grandeur de sortie qui agit sur le processus physique,

le DAP hybride étant lancé au moins par une fonctionnalité d'intégration, une fonctionnalité d'évaluation de conditions et, en cas d'identification d'une modification des conditions, par une fonctionnalité de détection de cohérence de grandeurs structurelles décisives et des parties du DAP hybride étant actives ou inactives en fonction des grandeurs structurelles décisives,

**caractérisé en ce que**

la fonction de détection de cohérence est exécutée dans une fonction triée (KHF, 1) de manipulation de consistance,

**en ce qu'**une première partie (2) de la KHF (1) triée comporte toutes les parties du DAP hybride indépendantes des conditions,

**en ce qu'**une deuxième partie (3) de la KHF triée (1) comporte toutes les parties du DAP hybride qui dépendent des conditions qui agissent sur les grandeurs structurelles décisives,

**en ce qu'**une troisième partie (4) de la KHF triée (1) comporte toutes les parties du DAP hybride qui dépendent des conditions et qui n'agissent sur aucune des grandeurs structurelles décisives,

**en ce qu'**en cas d'une modification des conditions, la première partie (2) et la troisième partie (4) de la KHF triée (1) sont exécutées une seule fois et seule la deuxième partie (3) de la KHF structurée (1) est exécutée éventuellement plusieurs fois pour la détection d'un ensemble cohérent de grandeurs structurelles décisives et

**en ce que** la KHF triée (1) est également exécutée lors de chaque exécution de la fonction d'intégration.

2. Procédé selon la revendication 1, **caractérisé en ce que** dans la deuxième partie (3) de la fonction triée (1) de manipulation de consistance, les parties du DAP hybride sont divisées en chaînes causales de grandeurs structurelles décisives et seules les chaînes causales dans lesquelles des grandeurs structurelles décisives se sont modifiées sont calculées de nouveau.

3. Programme informatique doté de moyens de code de programme permettant d'exécuter toutes les étapes selon les revendications précédentes réalisées à l'aide du calculateur de processus lorsque le programme est exécuté sur un calculateur de processus.

4. Programme informatique doté de moyens de code de programme selon la revendication 3 conservés en mémoire sur un support de données lisibles par ordinateur.

Fig. 1

Fig. 2

Fig. 3